(19) Europäisches Patentamt
European Patent Office
Office européen des brevets

(11) **EP 4 350 025 A1**

(12) **EUROPEAN PATENT APPLICATION**

(43) Date of publication:
**10.04.2024 Bulletin 2024/15**

(21) Application number: **23197691.1**

(22) Date of filing: **15.09.2023**

(51) International Patent Classification (IPC):
*C23C 14/00* (2006.01)   *C23C 14/04* (2006.01)
*C23C 14/34* (2006.01)   *C23C 14/35* (2006.01)
*C23C 14/54* (2006.01)   *H01J 37/34* (2006.01)
*C03C 17/36* (2006.01)

(52) Cooperative Patent Classification (CPC):
**C23C 14/542; C03C 17/3681; C23C 14/0015;
C23C 14/044; C23C 14/3407; C23C 14/3492;
C23C 14/354; H01J 37/32403; H01J 37/3417;
H01J 37/3426; H01J 37/3452; H01J 37/3458;**
H01J 37/347

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **20.09.2022 US 202263408404 P
10.08.2023 US 202318447918**

(71) Applicant: **Apple Inc.
Cupertino, CA 95014 (US)**

(72) Inventor: **VEERASAMY, Vijayen S
Cupertino, 95014 (US)**

(74) Representative: **COPA Copenhagen Patents
Rosenørns Allé 1, 2nd floor
1970 Frederiksberg C (DK)**

(54) **COATINGS FOR CURVED SURFACES**

(57) A transparent structure may have multiple layers, such as an inner layer and an outer layer, which may be formed from glass. The transparent structure may have a large, curved surface with compound curvature and high geometric strain and may include one or more layers. To apply a physical vapor deposition coating with uniform thickness on a curved surface, cathode power may be modulated during the deposition, a mask having an opening with a curvature matching the curved surface may be used, a cathode shape may be varied, the cathodes may sputter the coating outwardly toward the curved surface, a magnetic field may modulate the flux produced by the cathodes, and/or the pressure and/or flow of gas may be adjusted. By modifying the physical vapor deposition coater in one or more of these ways, the coating may have a uniform thickness, and therefore a uniform color, across the curved surface.

FIG. 2

## Description

This application claims priority to U.S. patent application No. 18/447,918, filed August 10, 2023, and U.S. provisional patent application No. 63/408,404, filed September 20, 2022, which are hereby incorporated by reference herein in their entireties.

## Field

This relates generally to structures that pass light, and, more particularly, to windows.

## Background

Windows generally include transparent layers, such as glass layers. Coatings may be applied to the transparent layers.

## Summary

A system such as a vehicle, a building, or an electronic device may have windows. A window may separate an interior region from an exterior region, such as the interior and exterior regions of a vehicle. A window may have structural window layers such as an inner layer and an outer layer. The inner and outer layers may be separated by an air gap.

The window may be a large, curved window with compound curvature and high geometric strain. One or more physical vapor deposition coatings may be applied to the inner and/or outer layers. To apply the physical vapor deposition coatings on the window layer with a uniform thickness, cathode power may be modulated during the deposition, a mask having an opening with a curvature based on the window curvature may be used, a cathode shape may be varied, the cathodes may sputter the coating outwardly toward the window, a magnetic field may modulate the flux produced by the cathodes, and/or gas pressure and/or gas flow may be adjusted.

By modifying the physical vapor deposition coater in one or more of these ways, the coating may have a uniform thickness, and therefore a uniform color, across a surface of the window layer.

## Brief Description of the Drawings

FIG. 1 is a schematic diagram of an illustrative apparatus in accordance with some embodiments.

FIG. 2 is a cross-sectional side view of an illustrative window having a coating in accordance with some embodiments.

FIG. 3 is a cross-sectional side view of an illustrative coating on a window layer in accordance with some embodiments.

FIG. 4 is a perspective view of an illustrative curved window layer in accordance with some embodiments.

FIGS. 5 and 6 are cross-sectional side views of the illustrative curved window layer of FIG. 4 in accordance with some embodiments.

FIG. 7 is a top view of an illustrative physical vapor deposition coater in accordance with some embodiments.

FIG. 8 is a graph of an illustrative power modulation of a cathode in a physical vapor deposition coater in accordance with some embodiments.

FIG. 9 is a side view of an illustrative mask through which a coating may be applied to a substrate in accordance with some embodiments.

FIG. 10 is a side view of an illustrative cylindrical cathode in accordance with some embodiments.

FIG. 11 is a side view of an illustrative frame-shaped cathode sputtering a coating onto a substrate in accordance with some embodiments.

FIG. 12 is a top view of an illustrative physical vapor deposition coater having inner cathodes that coat substrates by sputtering outwardly in accordance with some embodiments.

FIG. 13 is a top view of an illustrative physical vapor deposition coater having electromagnetics to change the thickness of the applied physical vapor deposition coating in accordance with some embodiments.

FIG. 14 is a side view of an illustrative hollow-tiled magnetron in accordance with some embodiments.

FIG. 15 is a graph of illustrative uniformity of a physical vapor deposition coating across a substrate in accordance with some embodiments.

## Detailed Description

A system may have windows. The windows may include optical coatings, such as coatings for blocking infrared light. Optionally, additional coatings, such as antireflection layers, or electro-optically adjustable components may also be incorporated into the windows. The system may be an electronic device, a building, a vehicle, or other suitable system. Illustrative configurations in which the system with the windows is a vehicle may sometimes be described herein as an example. This is merely illustrative. Window structures may be formed in any suitable system.

The electrically adjustable components of the windows may be used to adjust the optical properties of the windows. For example, electrically adjustable windows may be adjusted to change the absorption of light and therefore the light transmission of the windows. An adjustable light modulator layer may, for example, serve as an electrically adjustable sunroof for a rooftop window or may be used to implement an electrically adjustable shade for a side, front, or rear window. In an illustrative configuration, the transparency of the window may be modulated using a liquid crystal light modulator such as a guest-host liquid crystal light modulator. Adjustable optical component layers may also be used to display images, to provide illumination, and/or to otherwise adjust the appearance and behavior of a window.

A window for the system may include multiple glass layers. For example, a window may include an inner transparent structural layer (sometimes referred to as an inner glass layer) and an outer transparent structural layer (sometimes referred to as an outer glass layer). The inner and outer layers of the window may be separated by a gap. The gap may be filled with air or may be filled with a polymer, liquid, or other functional dielectric. Illustrative configurations in which the inner and outer glass layers are separated by air are sometimes described herein as an example.

The glass layers of a window may be single-layer glass layers (e.g., single layers of heat strengthened or tempered glass) or, in some configurations, may be multi-layer structures formed, for example, from first and second glass layers that are laminated together. A laminated glass layer may have a polymer such as polyvinyl butyral (PVB) that joins first and second glass layers to form a sheet of laminated glass. Multi-layer glass structures (laminated glass layers formed from two or more laminated glass layers with interposed PVB) and single-layer glass layers may include optional tinting (e.g., dye, pigment, etc.). Polymer layers in laminated glass layers (e.g., PVB layers) may also optionally be passively tinted.

As an alternative to glass, polymer layers may be used in forming windows. For example, windows may include one or more polymer layers, such as polycarbonate or acrylic layers. Laminated window structures may be formed from multiple polymer layers with an interlayer, such as a thermoplastic urethane (TPU) interlayer. In general, any desired interlayer may be used.

Regardless of the material used in forming window structures, the structures may be curved. For example, a window layer may have compound curvature and a geometric strain of at least 0.1%, at least 0.5%, at least 0.8%, at least 5%, or other desired value. It may be desirable to apply one or more coatings to the window layer. In some embodiments, physical vapor deposition coatings may be applied to the layer. The physical vapor deposition coatings may be sputtered onto the layer using a physical vapor deposition coater having one or more cathodes.

To ensure uniformity of the physical vapor deposition coatings on the window layer, power supplied to the one or more cathodes may be varied as the curvature of the window layer changes; a mask having an opening based on the curvature may be used between the cathodes and the window layer; a cathode having a cylindrical shape with twisted magnets or a cathode having a frame-shape may be used; the physical vapor deposition coater may have inner cathodes that sputter outwardly toward the window layer; electromagnets may be used to change the flux emitted by the coater and therefore the thickness of the coating; the coater may include magnetrons that match the curvature of the window layer; and/or the gas pressure and/or gas flow (e.g., of the gas that is being used for physical vapor deposition) may be adjusted.

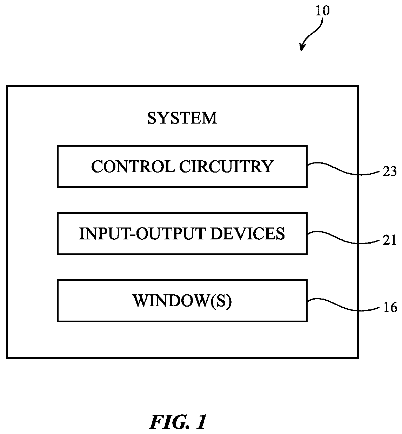

An illustrative system of the type that may include windows with one or more physical vapor deposition coating layers is shown in FIG. 1. System 10 may be an electronic device, a vehicle, a building, or any other desired system. For example, system 10 may be an electronic device, such as a cell phone, a laptop computer, a desktop computer, a tablet computer, a television, or any other desired electronic device. The electronic device may include a device housing, a display on a front face of the device housing, and electronic components within the device housing. In other examples, system 10 may be a vehicle having a body with a chassis to which wheels are mounted, propulsion and steering systems, and other vehicle systems. The vehicle body may include doors, trunk structures, a hood, side body panels, a roof, and/or other body structures. Seats may be formed in the interior of the body. However, these examples are merely illustrative. In general, system 10 may be any desired system.

Regardless of the particular system, system 10 may include one or more windows such as window(s) 16. Windows 16 may separate the interior of system 10 from the exterior environment that is surrounding system 10. For example, windows 16 may include windows on the front and/or rear of an electronic device; on the front, rear, top, and/or sides of a vehicle; or on the sides of a building, as examples.

Input-output devices 21 may include sensors, audio components, displays, and other components. For example, input-output devices 21 may provide output to an occupant of a vehicle, may make measurements of the environment surrounding the vehicle, and may gather input from an occupant of the vehicle. If desired, some of the input-output devices may operate through window(s) 16. In some examples, input-output devices 21 may include communication devices, such as radios, that receive and/or send radio waves through window(s) 16.

Control circuitry 23 may include storage and processing circuitry such as volatile and non-volatile memory, microprocessors, application-specific integrated circuits, digital signal processors, microcontroller, and other circuitry for controlling the operation of the system, such as the vehicle. During operation, control circuitry 23 may control the components of the vehicle based on input from input-output devices 21.

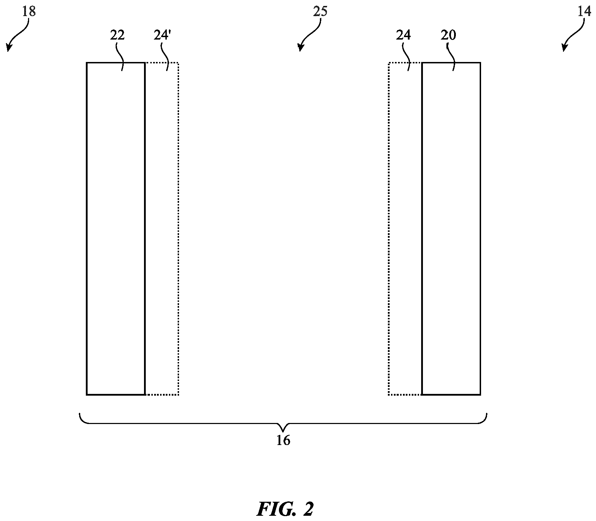

An illustrative configuration for a window such as one of windows 16 of FIG. 1 is shown in FIG. 2. As shown in FIG. 2, window 16 may separate interior region 14 (e.g., a region inside system 10, such as a region inside a vehicle) from exterior region 18 (e.g., a region on the outside of system 10, such as region outside the vehicle). Window 16 may include inner layer 20 and outer layer 22. Layers 20 and 22 may be glass layers, ceramic layers, sapphire layers, polymer layers (such as polycarbonate or acrylic layers), or any other desired layers, and may be transparent or partially transparent (e.g., may be tinted to reduce the transmission of some visible light). Layers 20 and 22 may be also referred to as substrates herein (e.g., when coatings are applied to the layers).

Layers 20 and 22 may be formed from single-layer glass structures and/or multi-layer glass structures. These single layer glass structures may be strengthened (e.g., by annealing, heat-strengthening, tempering, and/or chemical strengthening). In general, inner layer 20 may be a single-layer glass structure (e.g., a single layer of tempered glass) or a laminated glass layer and outer layer 22 may be a single-layer glass structure (e.g., a single layer of tempered glass) or a laminated glass layer. In embodiments in which layer 20 and/or layer 22 are laminated glass layers, they may include multiple layers of glass that are laminated together using one or more polymer layers. In embodiments in which layer 20 and/or layer 22 are laminated polymer layers, they may include multiple layers of polymer that are laminated together using one or more additional polymer layers. The polymer layers may be a layer of polyvinyl butyral, thermoplastic polyurethane, or other suitable polymer for attaching the glass layers.

Layers 20 and 22 may be separated by gap 25. Gap 25 may be an air gap, a vacuum, or gap 25 may be filled with any desired substance. For example, gap 25 may be filled with a polymer, gas, liquid, or other dielectric. In some cases, gap 25 may be omitted, if desired.

Light may be incident on window 16. For example, light may be incident on window 16 from exterior region 18, and/or light may be incident on window 16 from interior region 14. The light may include visible, infrared, ultraviolet, and other wavelengths. To reduce the transmission of undesirable wavelengths of light (such as infrared wavelengths) through window 16, inner layer 20 may be coated with physical vapor deposition coating 24. For example, physical vapor deposition coating 24 may be an infrared reflection coating that includes a plurality of thin-film layers (such as at least one silver layer) that prevent infrared light from reaching interior region 14 (e.g., reduces the transmission of infrared light through the window by at least 70%, at least 50%, at least 40%, or other value). In general, however, physical vapor deposition coating 24 may be any desired physical vapor deposition coating, such as a coating that blocks one or more desired wavelengths of light (e.g., ultraviolet light), an antireflection coating formed from a thin-film interference filter having a stack of dielectric layers with alternating indexes of refraction, and/or any other desired physical vapor deposition coating.

Although physical vapor deposition coating 24 is shown in FIG. 2 as being on the outer surface of inner layer 20, this is merely illustrative. As shown in FIG. 2, physical vapor deposition coating 24 may be at location 24' on the inner surface of outer layer 22 instead of or in addition to being on inner layer 20. Alternatively or additionally, physical vapor deposition coating 24 may be formed on the outside of window 16 (e.g., on the outer surface of outer layer 22 or the inner surface of inner layer 20), or may be formed on an additional layer that is formed between inner layer 20 and outer layer 22. In general, physical vapor deposition coating 24 may be formed anywhere within window 16.

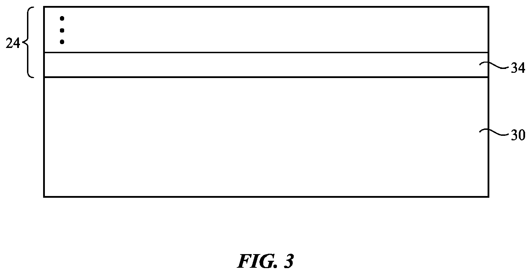

Regardless of where one or more physical vapor deposition coatings, such as physical vapor deposition coating 24, are formed, the physical vapor deposition coatings may include multiple layers. For example, a physical vapor deposition coating may include multiple layers to form an infrared reflection coating, a thin-film interference filter, or other desired coating. An illustrative stack up of a physical vapor deposition coating is shown in FIG. 3.

As shown in FIG. 3, physical vapor deposition coating 24 may be applied to substrate 30. Substrate 30 may be, for example, a window layer such as window layer 20 or 22 of FIG. 2. Physical vapor deposition coating 24 may include one or more physical vapor deposition coating layers 34. Each of layers 34 may include a different material, or layers 34 may include alternating materials. In some embodiments, physical vapor deposition coating 24 may include multiple thin-film layers that have alternating indexes of refraction to form a thin-film interference filter.

Although physical vapor deposition coating 24 is shown as being directly on substrate 30, this is merely illustrative. One or more layers may be incorporated in between physical vapor deposition coating 24 and substrate 30, if desired. In some embodiments, a buffer layer, such as a polymer layer, may be incorporated between substrate 30 and physical vapor deposition coating 24 to reduce the stress applied to substrate 30 during the physical vapor deposition process.

The windows in system 10 (e.g., windows 16) may be completely planar (e.g., the inner and outer surfaces of a window may be flat) and/or some or all of the windows in system 10 may have surface curvature. The inner and outer surfaces of each window may as an example, have compound curvature (e.g., non-developable surfaces characterized by curved cross-sectional profiles taken along the X and Y directions) and/or may have developable surfaces (surfaces with zero Gaussian curvature that can be flattened without distortion). Curved window shapes may be formed by heating glass until the glass is sufficiently soft to shape (e.g., using a mold, using gravity, using glass slumping techniques, and/or using other glass shaping methods).

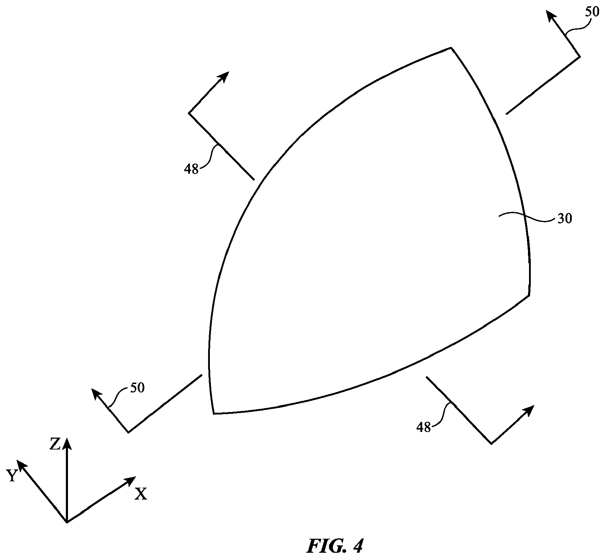

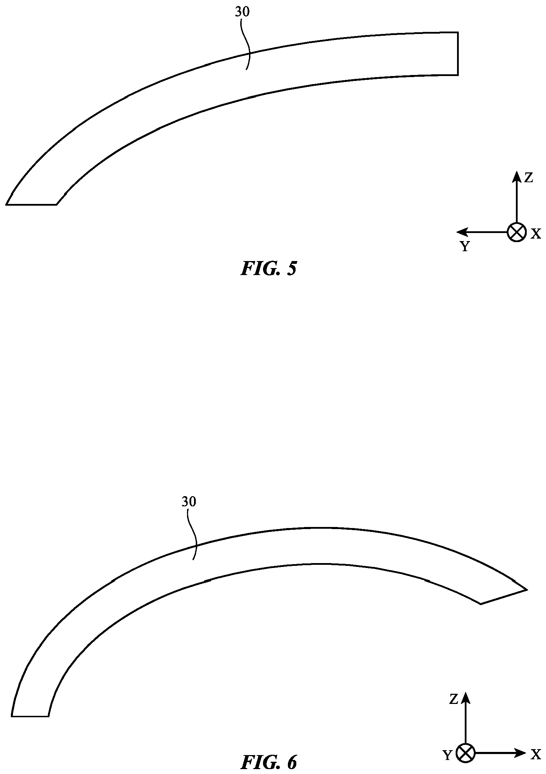

FIG. 4 is a perspective view of an illustrative curved window layer. In the example of FIG. 4, the surface of a window layer (formed by a transparent layer, such as layer 30 of FIG. 4) has compound curvature. In particular, layer 30 has a non-developable surface characterized by curved cross-sectional profiles taken along the X and Y directions of FIG. 3. FIG. 5 is a cross-sectional side view of layer 30 of FIG. 4 taken along lines 48 and viewed in the +X direction. As shown in FIG. 5, the cross-sectional profile of layer 30 viewed in the +X direction is curved. FIG. 6 is a cross-sectional side view of layer 30 of FIG. 4 taken along lines 50 of FIG. 4 and viewed in the +Y direction. As shown in FIG. 5, the cross-sectional profile of layer 30 viewed in the +Y direction is curved. Layers 30 with compound curvature may, if desired, also have one or more areas that are planar (not curved) and/or one or more areas that have developable surfaces (curved surface areas without compound curvature). In some configurations, a curved layer such as layer 30 may have only developable surfaces and no compound curvature (and may optionally have planar portions). Arrangements in which curved layers for window 14 such as layer 30 have only compound curvature or a combination of one or more areas of compound curvature and one or more flat areas may also be used. The process of forming layer 30 into a shape with a curved cross-sectional profile may sometimes be referred to as bending or shaping. One or more layers 30 may be used in forming window 16 and each layer 30 (and window 16) may have any suitable outline (rectangular, triangular, circular, shapes with curved edges and/or straight edges, etc.).

The amount of curvature of windows in system 10, such as windows 16, may be such that windows 16 exhibit a geometric strain value of at least 0.1%, at least 0.8%, at least 1%, at least 3%, at least 3.5%, at least 4%, at least 5%, between 3% and 7.5%, between 3.5% and 7%, between 4% and 6.5%, between 4.5 and 6%, less than 7%, less than 6.5%, or other suitable amount of geometric strain. Alternatively or additionally, windows 16 may be large (e.g., may have a large surface area in the X and Y directions of FIG. 4). For example, windows 16 may be at least 1 $m^2$, at least 1.5 $m^2$, at least 0.75 $m^2$, or have another desired surface area.

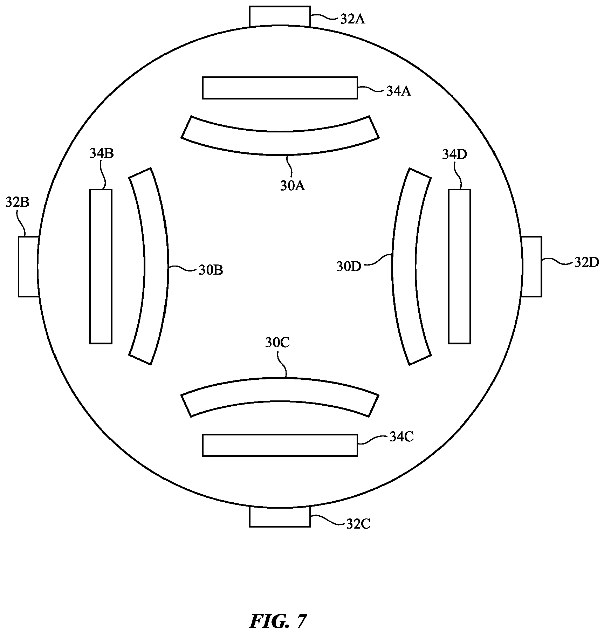

Due to the geometric strain and size of windows 16, it may be difficult to apply coatings to surfaces of windows 16. In particular, traditional processes may be unsuitable to handle such large windows (e.g., the processes may break the windows or subject the windows to excessive stress) or may be unable to uniformly coat windows with complex curvature. An illustrative physical vapor deposition coater that may be used in depositing physical vapor deposition coatings on windows 16 is shown in FIG. 7.

As shown in FIG. 7, physical vapor deposition coater 31 may include cathodes 32A, 32B, 32C, and 32D. Cathodes 32 may, for example, discharge plasma toward a target material (e.g., may bombard the target material), and some of the target material may be sputtered as a vapor that may deposit onto substrates 34. In this way, physical vapor deposition coatings may be sputtered onto substrates 30 using cathodes 32. However, this physical vapor deposition process is merely illustrative. In general, cathodes 32 may be used in any desired physical vapor deposition process to deposit physical vapor deposition coatings onto substrates 30.

Masks 34 may be interposed between cathodes 32 (and the target material) and substrates 30. For example, masks 34 may be finger masks that have one or more openings that are patterned to match a curvature of substrates 30. The sputtered (or otherwise emitted) material may pass through masks 34 prior to being deposited on substrates 30. Because masks 34 have openings based on the curvature of the substrates, the sputtered material may be deposited in a uniform manner across a surface of substrate 30. For example, the physical vapor deposition coatings may have a uniform thickness across the surface, even though the curvature of the surface is non-uniform. Depending on the curvature of substrates 30, however, masks 34 may be omitted, if desired.

While the physical vapor deposition coatings are being applied on substrates 30 using cathodes 32, substrates 30 may be rotated relative to cathodes 32, if desired (e.g., rotated about a midpoint of the physical vapor deposition coater so the substrates are exposed to deposition from all of the cathodes). Alternatively or additionally, cathodes 32 may be rotated relative to substrates 30 during the deposition process. By rotating substrates 30 and/or cathodes 32, the physical vapor deposition coatings formed on substrates 30 may be more uniform than if substrates 30 and cathodes 32 are stationary. If desired, the speed of rotation of substrates 30 relative to cathodes 32 (and masks 34) may be adjusted. Adjusting the speed based on the curvature of substrate 30, a more uniform coating may be achieved.

Other conditions may also be varied to account for the curvature of substrates 30. For example, the pressure of the system may be increased or decreased as needed to account for different curved regions of the substrate. Alternatively or additionally, the pressure of the gas used for the physical vapor deposition may be increased or decreased based on the curvature of the substrate. In one illustrative example, the working pressure of the system and/or the pressure of the gas may be on the order of 1 mTorr. However, the pressure may be increased, such as to approximately 4 mTorr or 5 mTorr to increase uniformity. These examples are merely illustrative of pressures that may be used, and are not limiting. Any suitable pressure may be used.

In general, adjusting the gas pressure may increase the uniformity of the coating. However, in embodiments in which a silver layer is being deposited (e.g., as part of an infrared reflection coating), higher pressures may reduce the silver quality. Therefore, the gas pressure may be selected as a trade-off based on the curvature of the substrate (e.g., a higher gas pressure may be used for a substrate with a higher curvature) and the needed silver quality (e.g., a lower gas pressure may be used if higher silver quality is needed for the given infrared reflection coating).

In addition to, or instead of, changing the gas pressure, the gas flow may be changed. In particular, the gas flow may be modified to change the stoichiometry of the deposited layers, especially when dielectric layers (such as thin-film interference layers) are being deposited. As an illustrative example, the flow of oxygen gas may be adjusted based on the shape of the substrate, as well as the desired coating material, to form a given layer with the correct stoichiometry (e.g., if a dielectric layer containing oxygen, such as $TiO_2$, TiZnO, or other dielectric layer, is being deposited). In some embodiments, the flow of oxygen or other gas may be changed across the substrate to modify the deposited coating across the surface of the substrate. In this way, desired coating(s) may be deposited on a curved substrate.

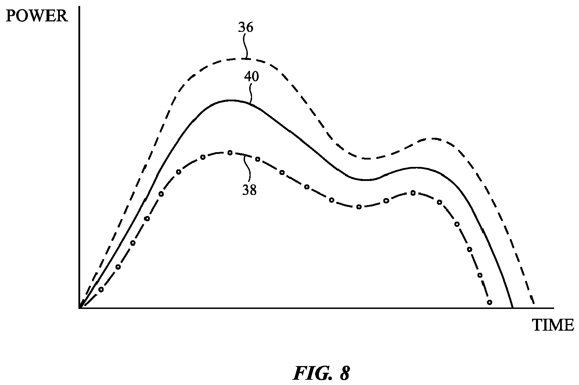

Because substrates 30 may have curved surfaces, such as surfaces with compound curvature having a geometric strain of at least 0.1%, at least 0.8%, at least 1%, at least 5% (or other desired strain), cathodes 32 may be modulated during the deposition process to provide coatings of uniform thickness on substrates 30. An illustrative example of modulating the power of cathodes in physical vapor deposition coater 31 is shown in FIG. 8.

As shown in FIG. 8, the power needed for cathodes, such as cathodes 32 of Fig. 7, to apply a uniform coating, may vary over time as the substrate is moved with respect to the cathode. In particular, curves 36 and 38 may be determined based on the differences in curvature of the substrate across different portions of the substrate. For example, curve 36 may reflect the amount of power needed to uniformly coat a first portion of the substrate, while curve 38 may reflect the amount of power needed to uniformly coat a second portion of the substrate. The local maxima of curves 36 and 38 may occur at times at which the substrate is further from the cathode and the target (e.g., more power is needed to apply a coating of uniform thickness when the substrate is further away), while the local minima of curves 36 and 38 may occur at times at which the substrate is closer to the cathode and target (e.g., less power is needed to apply a coating of uniform thickness when the substrate is closer). In other words, a dynamic deposition rate may be used by changing the power (e.g., the voltage) of sputtering. A high voltage will produce a high flux with high energy and may be used when the substrate is further from the cathode and target, while a low voltage will produce a low flux with low energy and may be used when the substrate is closer to the cathode and target.

Curve 40 may be a regression curve of curves 36 and 38. By modulating the power applied to the cathodes, such as cathodes 32, according to curve 40, the physical vapor deposition coating may be applied more uniformly than if the power was constant during the deposition process. In other words, modulating the power applied to the cathodes during the deposition process may result in a more uniform coating across a surface of the curved substrate.

Curves 36, 38, and 40 are merely illustrative examples of power modulation curves. In general, any desired number of individual power modulation curves may be determined for any desired number of substrate portions, and a regression power modulation curve may be determined from the individual power modulation curves. The regression power modulation curve may then be used to modulate the power applied to the cathodes during deposition, resulting in a more uniform coating across the substrate.

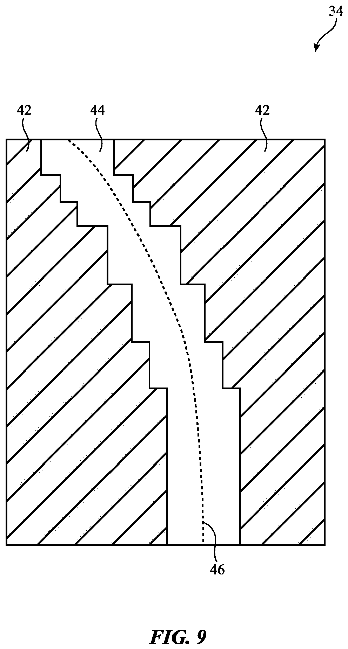

In addition to, or instead of, modulating the power of the cathodes during the deposition process, a mask may be used between the cathodes/targets and the substrates. As discussed in connection with FIG. 7, masks 34 may have openings that are based on/correspond with the curvature of the substrates. An illustrative mask having such an opening is shown in FIG. 9.

As shown in FIG. 9, a mask, such as mask 34, may include portions 42 and opening 44 between portions 42. Portions 42 may be formed from any desired material, such as metal, polymer, or other desired material. Opening 44 may have a curvature 46 that corresponds with or is based on the curvature of the substrate (such as substrate 30 of FIG. 7) on which the physical vapor deposition coating is applied. Because the substrate may be rotated during the deposition process (as discussed with respect to substrate 30 of FIG. 7), opening 44 may ensure that a uniform coating is applied to the substrate regardless of the curvature of the substrate at a given point.

To determine the shape of mask 34 (e.g., opening 44), the power modulation of FIG. 8, and/or other conditions of the deposition process, such as movement of the substrates, an iterative process may be used. For example, known properties of the coater (e.g., coater 31) may be used in combination with a plasma and transport simulation to determine the expected coating deposition on a substrate of given curvature. Different properties, such as the shape of mask 34, power modulation, speed of rotation, pressure, etc. may be modified in an iterative fashion to determine an optimal combination of conditions in which the coating will be uniform on the curved substrate. If desired, such a process may be completed for each substrate (e.g., each curvature) that will be coated. However, this iterative process is merely illustrative. In general, the coating parameters may be selected and/or calculated in any desired manner.

Opening 44 is merely illustrative. In general, opening 44 may have any desired shape that corresponds to the curvature of the substrate (e.g., an opening with a shape that facilitates uniform deposition across the curved substrate as the substrate is rotated relative to the cathode during the deposition process).

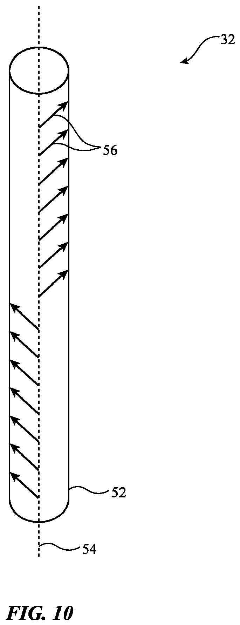

Alternatively or additionally to the use of mask 34, cathodes in the physical vapor deposition coater may be designed to provide a uniform coating across a curved substrate. For example, cathodes may be associated with twisted magnets that allow for continuous direction changes of the flux produced by the cathodes (and therefore of the direction of deposition) and/or may be a frame-shaped cathode. An illustrative example of a cathode that allows for continuous direction changes is shown in FIG. 10.

As shown in FIG. 10, a cathode, such as cathode 32, may have a cylindrical body 52 with axis of symmetry 54. As indicated by arrows 56, the direction of the flux produced by cathode 32 may be changed continuously in any desired direction around axis 54. For example, the flux produced by cathode 32 may be changed during the physical vapor deposition process based on the curvature of the substrate on which the physical vapor deposition coating is being applied. As the substrate is rotated relative to cathode 32, the curvature with respect to cathode 32 will change, and the direction of flux and therefore direction of sputtering may therefore be changed.

To provide the change in flux direction 56, twisted magnets associated with cathode 32 may be used. In particular, magnets may be wrapped around cathode 32 in a helical arrangement, or magnets may partially surround cathode 32. Regardless of the position of the magnets, the magnetic field produced by the magnets may be changed (e.g., the voltage applied to electromagnets may be changed) to change the direction of the flux produced by cathode 32. In this way, the direction of sputtering may be changed during the deposition process based on the curvature of the substrate, allowing for a more uniform physical vapor deposition coating.

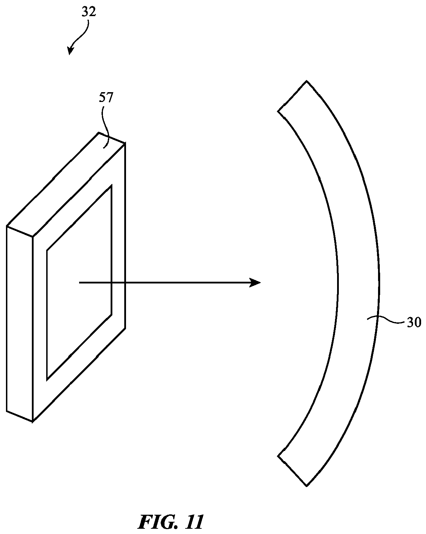

An illustrative example of a frame-shaped cathode that may be used in sputtering physical vapor deposition coatings on curved substrates is shown in FIG. 11. As shown in FIG. 11, a cathode, such as cathode 32, may have a frame-shaped body 57. Frame-shaped body 57 may surround a central portion through which ions may be emitted along a normal axis toward substrate 30 (with an intervening target not shown in FIG. 11). Using a frame-shaped cathode may improve the uniformity of coatings sputtered onto substrate 30, and may provide more space on the exterior of a physical vapor deposition coater, such as physical vapor deposition coater 31 of FIG. 7. In this way, the size requirements of the physical vapor deposition coater may be reduced, while improving the coater's capabilities of sputtering uniform physical vapor deposition coatings.

Although FIG. 11 shows cathode 32 as being a frame-shaped cathode in the shape of a square, this is merely illustrative. In general, cathode 32 may have any desired shape, such as a ring-shaped cathode.

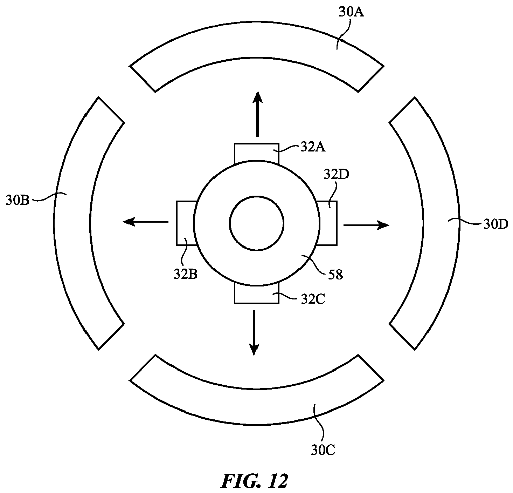

Instead of, or in addition to, modifying the cathodes, the physical vapor deposition coater itself may be modified to allow for uniform deposition on curved substrate. In particular, although FIG. 7 shows cathodes that sputter coatings inwardly onto substrates, the physical vapor deposition coater may be modified to have cathodes sputter coatings outwardly onto substrates. An illustrative physical vapor deposition coater that sputters coatings outwardly is shown in FIG. 12.

As shown in FIG. 12, cathodes 32 may be arranged around central structure 58 and may sputter physical vapor deposition coatings outwardly toward substrates 30. During deposition, substrates 30 may be rotated around cathodes 32 and central structure 58. The use of outward sputtering may improve uniformity of coatings on substrates 30 by at least 3%, by at least 5%, at least 10%, by approximately 20%, by at least 15%, or other value. For example, the coatings on substrates 30 that are deposited using an outward sputterer may have a uniformity of at least $\pm 3\%$, at least $\pm 2\%$, at least $\pm 1.5\%$, or other suitable uniformity over the entire surface of the substrate. Moreover, the outward sputtering of FIG. 12 may be used in combination with the power modulation of FIG. 8, the mask design of FIG. 9, and/or the cathodes of FIGS. 10 and 11, if desired, to provide a more uniform coating on a curved substrate.

Although FIG. 12 shows four cathodes batch coating four substrates, this is merely illustrative. In general, the physical vapor deposition coater may include any desired number of cathodes, such as five cathodes, six cathodes, less than five cathodes, or three cathodes, as examples. A corresponding number of substrates may be batch coated based on the number of cathodes. However, a different number of substrates than the number of cathodes (e.g., more or fewer substrates than the number of cathodes) may be batch coated, if desired.

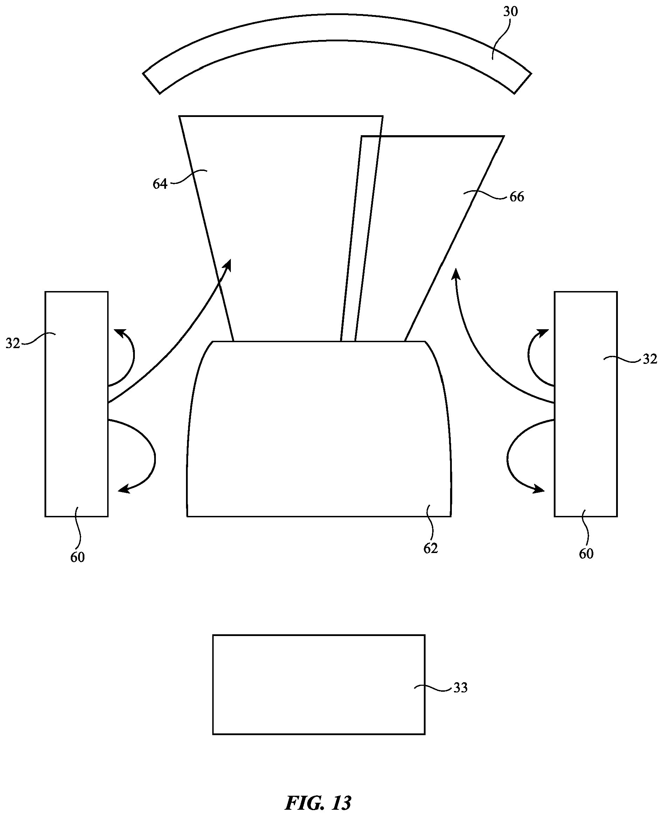

It may also be desirable to use magnets near the target to change the direction of sputtering based on the curvature of the substrate on which a physical vapor deposition coating is being applied. An illustrative example of using magnets in this way is shown in FIG. 13.

As shown in FIG. 13, cathodes 32 may produce fluxes 64 and 66 by emitting ions toward target 62. To account for differences in the curvature of substrate 30, electromagnets 60 may be positioned on both sides of target 62. As shown, electromagnets 60 associated with cathodes 32 may have magnetic fields that impact the direction of the flux. If one side of substrate 30 is closer to target 62 than another side, then it may be desirable to have an unbalanced flux, such that the flux is greater toward portions of substrate 30 that are further away. If, for example, substrate 30 is further away from cathodes 32 and target 62 on the left side of FIG. 13, left electromagnetic 60 may be adjusted (e.g., the voltage applied to left electromagnetic 60 may be increased) to have a greater magnetic field than right electromagnetic 60. In this way, flux 64 may be greater toward the left portion of substrate 30 than flux 66 toward the right portion of substrate 30, thereby coating substrate 30 uniformly.'

The example of FIG. 13, in which two cathodes 32 and two sets of electromagnets 60 are used in coating a single substrate, is merely illustrative. In general, any desired number of cathodes and any desired number of electromagnets may be used in a physical vapor deposition coater to form a desired number of fluxes and to adjust those fluxes, respectively. In one illustrative example, each of cathodes 32 may include multiple electromagnets 60 that extend from an end closest to magnetron 33 to an end closest to substrate 30. For example, each cathode 32 may include at least three, at least five, or any other desired number of electromagnets. By changing which of these multiple magnets is activated (e.g., on) in a single cathode, the length of the magnetic field, and therefore the length of the associated flux, may be increased.

In addition to, or instead of, having one or more fluxes that are varied based on substrate curvature, the one or more fluxes may be varied by time. In particular, a magnetic field may be increased at a first time when a portion of the substrate is further from the cathodes and decreased at a second time when a different portion of the substrate is closer to the cathodes. By modifying the magnetic field, and therefore the flux, over time, the coating may be applied more uniformly (e.g., the coating may match the curvature of the substrate). Additionally or alternatively, magnets 60 may be steered to adjust the angle of the flux and evenly distribute the coating across substrate 30.

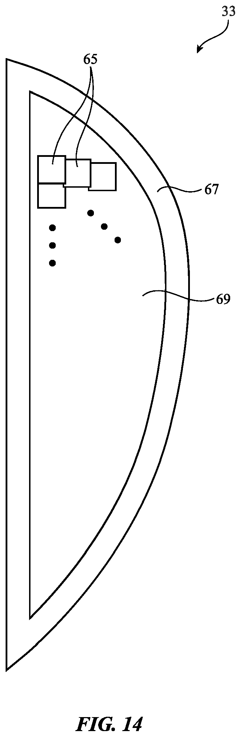

Magnetron 33 may also be included in the physical vapor deposition coater. Magnetron 33 may produce a magnetic field that matches the shape of substrate 30 and that steers the flux (e.g., fluxes 64 and 66) toward substrate 30. In some embodiments, magnetron 33 may have a shape that matches the shape of substrate 30. An illustrative example of a magnetron is shown in FIG. 14.

As shown in FIG. 14, a magnetron, such as magnetron 33, may have outer body portion 67 and a hollow inner portion 69. Hollow inner portion 69 may be tiled with tiles 65, if desired. Outer body portion 67 and inner portion 69 may have shapes that match the curvature of substrate 30. In this way, the magnetic field produced by magnetron 33 (e.g., the magnetic field produced in response to voltage applied to magnetron 33) may also have a shape that matches the curvature of substrate 30. Because the produced magnetic field moves the ionic flux toward substrate 30, the resulting coating may therefore be applied to substrate 30 in a uniform manner.

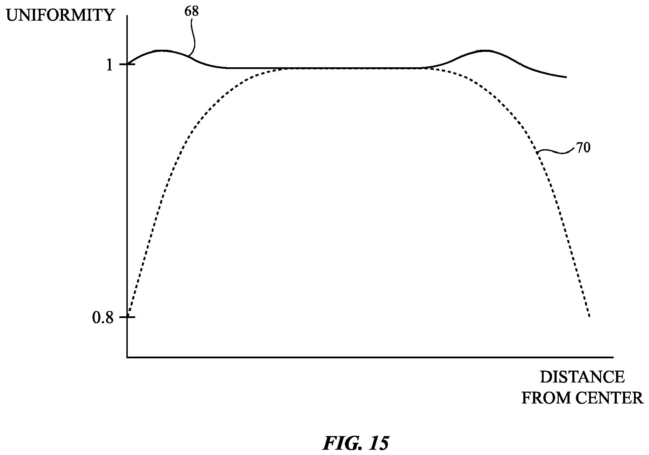

Multiple ways of improving uniformity on a curved substrate, such as a substrate with compound curvature and a large geometric strain, have been described. In particular, the power modulation of FIG. 8, the mask design of FIG. 9, the cathode designs of FIGS. 10 and 11, the outward sputtering of FIG. 12, the unbalanced magnetic fields of FIG. 13, and the magnetron design of FIG. 14 may all improve coating uniformity. An illustrative graph showing an improvement of uniformity using one or more of these methods is shown in FIG. 15.

As shown in FIG. 15, curve 68 may correspond to the uniformity of a coating over a substrate when applied using one or more of the methods of FIGS. 7-14, while curve 70 may correspond to the uniformity of a coating over a substrate when applied without any of these methods. Curve 70 shows that such a coating is non-uniform, especially at the edges of the substrate. In contrast, a coating formed using one or more of the uniformity improvements of FIGS. 7-14 may have a thickness that varies less than 5%, less than 4%, less than 2%, less than 3%, approximately 2.5%, 2.5% or less, less than 1.5%, less than 0.5%, or other desired amount over the entire substrate (e.g., the entire surface of the substrate).

Because of the uniformity of the coating thickness, the coating may also have a uniform color across the surface of the substrate. In particular, the coating may have a color difference $\Delta E$ in LAB color space (such as $\Delta E_{94}$ or $\Delta E_{2000}$) that is less than 1.4, less than 1.0, or other desired value across the entirety of the surface (as compared to the uncoated window). $\Delta E$ refers to the total color difference in LAB color space. An illustrative $\Delta E$ formula is given by Equation 1:

$$\Delta E = \sqrt{(L_2 - L_1)^2 + (a_2 - a_1)^2 + (b_2 - b_1)^2} \qquad (1)$$

where L (also referred to as L*) is the luminance of light passing through the window, and a (also referred to as a*) and b (also referred to as b*) are the color coordinates of the light passing through the window. The a and b color coordinates refer to red/gray and blue/yellow differences, respectively. The L, a, and b differences compare the L, a, and b values of light through the window with the physical vapor deposition coating and the L, a, and b values of light through the uncoated window. The physical vapor deposition coating may therefore only change the color of light through the window (ΔE) by 1.0, or 1.4, as examples. In this way, the physical vapor deposition layer may impart a low color change to the window.

Moreover, if desired, a coating may be applied that is thicker toward the edges of the substrate than at the middle of the substrate (e.g., by adjusting the rotation speed of the substrate relative to the cathode and mask and/or by adjusting the pressure of the system). For example, an optical filter coating applied on a convex lens may be applied with a larger thickness at the edge of the lens than at the center of the lens. In particular, the optical filter may have a filtering property that changes based on the angle of incidence of light passing through the filter. It may be desirable to prevent a shift in the spectral curve of the coating at these high angles. By making the coating thicker at the edge of the lens, the spectral curve may not shift (or may shift less), and the spectral shift may be mitigated at high angles. Although the thicker deposition at the edge of the substrate is described with respect to a convex lens, this is merely illustrative. In general, a coating may be applied with increased thickness at the edge on any desired substrate.

By using one or more of the methods in FIGS. 7-14, coatings with uniform thicknesses, and therefore a small color change, may be formed over large substrates having compound curvature (and large geometric strain).

In accordance with an embodiment, a window is provided that includes a window layer includes a surface, the window layer has a geometric strain of at least 0.8% and a physical vapor deposition coating on the surface of the window layer, the physical vapor deposition coating is an infrared reflective coating, and the physical vapor deposition coating has a thickness that varies less than 3% across the surface.

In accordance with another embodiment, the window layer has an area of at least 1 m$^2$, the thickness of the physical vapor deposition coating varies 2.5% or less across the surface of the window layer, and the physical vapor deposition coating has a ΔE that is less than 1 across the surface of the window layer.

In accordance with another embodiment, the thickness of the physical vapor deposition coating varies less than 1.5% across the surface of the window layer.

In accordance with another embodiment, the physical vapor deposition coating has a ΔE of less than 1.4 across the surface of the window layer.

In accordance with another embodiment, the ΔE of the physical vapor deposition coating is less than 1 across the surface of the window layer.

In accordance with another embodiment, the window layer has a portion with compound curvature, and the physical vapor deposition coating is applied to the portion of the window layer.

In accordance with another embodiment, the window layer has an area of at least 1 m2.

In accordance with another embodiment, the physical vapor deposition coating has a ΔE of less than 1 in LAB color space across an entirety of the surface of the window layer.

In accordance with another embodiment, the thickness of the physical vapor deposition coating varies 2.5% or less across the surface of the window layer.

In accordance with another embodiment, the physical vapor deposition coating includes a plurality of thin-film coating layers that form the infrared reflective coating, and the plurality of thin-film coating layers includes at least one silver layer.

In accordance with an embodiment, a method of applying a physical vapor deposition coating to a curved window layer is provided that includes using a cathode, sputtering a physical vapor deposition coating layer onto the curved window layer through a mask having an opening that matches a curvature of the curved window and while sputtering the physical vapor deposition coating layer, modulating power applied to the cathode based on the curvature of the curved window layer.

In accordance with another embodiment, the method includes while sputtering the physical vapor deposition coating layer, rotating the window layer.

In accordance with another embodiment, sputtering the physical vapor deposition coating layer onto the curved window layer includes sputtering the physical vapor deposition coating layer from an inner cathode outwardly toward the curved window layer.

In accordance with another embodiment, the method includes adjusting an electromagnet to change a magnetic field between the cathode and the curved window while sputtering the physical vapor deposition coating layer.

In accordance with another embodiment, sputtering the physical vapor deposition coating layer includes depositing the physical vapor deposition coating layer on the curved window layer with a thickness that varies 2.5% or less across a curved surface of the curved window layer.

In accordance with another embodiment, sputtering the physical vapor deposition coating layer includes using a frame-shaped cathode to sputter the physical vapor deposition coating layer in a normal direction onto the curved window layer.

In accordance with another embodiment, the method includes while sputtering the physical vapor deposition coating layer, continuously changing a direction of the sputtering by adjusting magnets associated with the cathode.

In accordance with another embodiment, the method includes while sputtering the physical vapor deposition coating layer, adjusting a pressure of a gas used to sputter the physical vapor deposition coating layer.

In accordance with another embodiment, the method includes while sputtering the physical vapor deposition coating layer, adjusting a flow of the gas used to sputter the physical vapor deposition coating layer.

In accordance with another embodiment, adjusting the pressure and the flow of gas includes adjusting the pressure and the flow of oxygen gas.

In accordance with an embodiment, a window is provided that includes a glass layer with compound curvature and a physical vapor deposition coating on the compound curvature of the glass layer, the physical vapor deposition coating is an infrared reflective coating, and the physical vapor deposition coating has a thickness that varies 2.5% of less across the glass layer.

In accordance with another embodiment, the glass layer has a geometric strain of at least 0.8%.

In accordance with another embodiment, the physical vapor deposition coating has a $\Delta E$ in LAB color space of less than 1.4 across an entirety of the glass layer.

Accordingly, exemplary embodiments of the present disclosure are set out in the following items:

1. A window, comprising:

a window layer comprising a surface, wherein the window layer has a geometric strain of at least 0.8%; and
a physical vapor deposition coating on the surface of the window layer, wherein the physical vapor deposition coating is an infrared reflective coating, and wherein the physical vapor deposition coating has a thickness that varies less than 3% across the surface.

2. The window of item 1, wherein the window layer has an area of at least 1 m$^2$, wherein the thickness of the physical vapor deposition coating varies 2.5% or less across the surface of the window layer, and wherein the physical vapor deposition coating has a $\Delta E$ that is less than 1 across the surface of the window layer.

3. The window of any of items 1-2, wherein the thickness of the physical vapor deposition coating varies less than 1.5% across the surface of the window layer.

4. The window of any of items 1-3, wherein the physical vapor deposition coating has a $\Delta E$ of less than 1.4 across the surface of the window layer.

5. The window of item 4, wherein the $\Delta E$ of the physical vapor deposition coating is less than 1 across the surface of the window layer.

6. The window of any of items 1-5, wherein the window layer has a portion with compound curvature, and the physical vapor deposition coating is applied to the portion of the window layer.

7. The window of any of items 1-6, wherein the window layer has an area of at least 1 m$^2$.

8. The window of item 7, wherein the physical vapor deposition coating has a $\Delta E$ of less than 1 in LAB color space across an entirety of the surface of the window layer.

9. The window of item 8, wherein the thickness of the physical vapor deposition coating varies 2.5% or less across the surface of the window layer.

10. The window of any of items 1-9, wherein the physical vapor deposition coating comprises a plurality of thin-film coating layers that form the infrared reflective coating, and wherein the plurality of thin-film coating layers comprises at least one silver layer.

11. A method of applying a physical vapor deposition coating to a curved window layer, comprising:

using a cathode, sputtering a physical vapor deposition coating layer onto the curved window layer through a mask having an opening that matches a curvature of the curved window; and
while sputtering the physical vapor deposition coating layer, modulating power applied to the cathode based on the curvature of the curved window layer.

12. The method of item 11, further comprising:

while sputtering the physical vapor deposition coating layer, rotating the window layer.

13. The method of any of items 11-12, wherein sputtering the physical vapor deposition coating layer onto the curved window layer comprises sputtering the physical vapor deposition coating layer from an inner cathode outwardly toward the curved window layer.

14. The method of any of items 11-13, further comprising:
adjusting an electromagnet to change a magnetic field between the cathode and the curved window while sputtering the physical vapor deposition coating layer.

15. The method of any of items 11-14, wherein sputtering the physical vapor deposition coating layer comprises depositing the physical vapor deposition coating layer on the curved window layer with a thickness that varies 2.5% or less across a curved surface of the curved window layer.

16. The method of any of items 11-15, wherein sputtering the physical vapor deposition coating layer comprises using a frame-shaped cathode to sputter the physical vapor deposition coating layer in a normal direction onto the curved window layer.

17. The method of any of items 11-16, further comprising:
while sputtering the physical vapor deposition coating layer, continuously changing a direction of the sputtering by adjusting magnets associated with the cathode.

18. The method of any of items 11-17, further comprising:
while sputtering the physical vapor deposition coating layer, adjusting a pressure of a gas used to sputter the physical vapor deposition coating layer.

19. The method of item 18, further comprising:
while sputtering the physical vapor deposition coating layer, adjusting a flow of the gas used to sputter the physical vapor deposition coating layer.

20. The method of item 19, wherein adjusting the pressure and the flow of gas comprises adjusting the pressure and the flow of oxygen gas.

21. A window, comprising:

a glass layer with compound curvature; and
a physical vapor deposition coating on the compound curvature of the glass layer, wherein the physical vapor deposition coating is an infrared reflective coating, and wherein the physical vapor deposition coating has a thickness that varies 2.5% of less across the glass layer.

22. The window of item 21, wherein the glass layer has a geometric strain of at least 0.8%.

23. The window of item 22, wherein the physical vapor deposition coating has a $\Delta E$ in LAB color space of less than 1.4 across an entirety of the glass layer.

The foregoing is merely illustrative and various modifications can be made to the described embodiments. The foregoing embodiments may be implemented individually or in any combination.

**Claims**

1.  A window, comprising:

a window layer comprising a surface, wherein the window layer has a geometric strain of at least 0.8%; and
a physical vapor deposition coating on the surface of the window layer, wherein the physical vapor deposition coating is an infrared reflective coating, and wherein the physical vapor deposition coating has a thickness that varies less than 3% across the surface.

2. The window of claim 1, wherein the window layer has an area of at least 1 m$^2$, wherein the thickness of the physical vapor deposition coating varies 2.5% or less across the surface of the window layer, and wherein the physical vapor deposition coating has a $\Delta$E that is less than 1 across the surface of the window layer.

3. The window of any of claims 1-2, wherein the thickness of the physical vapor deposition coating varies less than 1.5% across the surface of the window layer.

4. The window of any of claims 1-3, wherein the physical vapor deposition coating has a $\Delta$E of less than 1.4 across the surface of the window layer.

5. The window of claim 4, wherein the $\Delta$E of the physical vapor deposition coating is less than 1 across the surface of the window layer.

6. The window of any of claims 1-5, wherein the window layer has a portion with compound curvature, and the physical vapor deposition coating is applied to the portion of the window layer.

7. The window of any of claims 1-6, wherein the window layer has an area of at least 1 m$^2$.

8. The window of claim 7, wherein the physical vapor deposition coating has a $\Delta$E of less than 1 in LAB color space across an entirety of the surface of the window layer.

9. The window of claim 8, wherein the thickness of the physical vapor deposition coating varies 2.5% or less across the surface of the window layer.

10. The window of any of claims 1-9, wherein the physical vapor deposition coating comprises a plurality of thin-film coating layers that form the infrared reflective coating, and wherein the plurality of thin-film coating layers comprises at least one silver layer.

11. The window of any of claims 1-10, wherein the window layer comprises a glass layer with compound curvature, and wherein the physical vapor deposition coating has a thickness that varies 2.5% of less across the glass layer.

12. The window of claim 11, wherein the physical vapor deposition coating has a $\Delta$E in LAB color space of less than 1.4 across an entirety of the glass layer.

10

```
┌─────────────────────────────────────────┐
│               SYSTEM                      │
│   ┌───────────────────────────────┐       │
│   │      CONTROL CIRCUITRY        │───── 23│
│   └───────────────────────────────┘       │
│   ┌───────────────────────────────┐       │
│   │     INPUT-OUTPUT DEVICES      │───── 21│
│   └───────────────────────────────┘       │
│   ┌───────────────────────────────┐       │
│   │         WINDOW(S)             │───── 16│
│   └───────────────────────────────┘       │
└─────────────────────────────────────────┘
```

*FIG. 1*

**FIG. 2**

**FIG. 3**

**FIG. 4**

**FIG. 5**

**FIG. 6**

**FIG. 7**

*FIG. 8*

**FIG. 9**

**FIG. 10**

**FIG. 11**

**FIG. 12**

**FIG. 13**

**FIG. 14**

*FIG. 15*

Europäisches
Patentamt

European
Patent Office

Office européen
des brevets

# EUROPEAN SEARCH REPORT

Application Number

EP 23 19 7691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 436 741 B1 (ASAHI GLASS CO LTD [JP]) 26 June 1996 (1996-06-26) * page 3, line 36 - page 4, line 11 * * page 7, lines 48-55 * * page 11, lines 36-45 * ----- | 1-12 | INV. C23C14/00 C23C14/04 C23C14/34 C23C14/35 C23C14/54 |
| X | US 6 838 181 B1 (DEGAND ETIENNE [BE]) 4 January 2005 (2005-01-04) * claims 3,7,11,12 * ----- | 1-12 | H01J37/34 C03C17/36 |
| X | US 2003/132101 A1 (IKADAI MASAHIRO [JP] ET AL) 17 July 2003 (2003-07-17) * paragraphs [0081], [0098]; figures 3-4 * ----- | 1-12 | |
| X | CN 103 726 019 A (SHANGHAI INST OPTICS & FINE ME) 16 April 2014 (2014-04-16) * the whole document * ----- | 1-12 | |

TECHNICAL FIELDS
SEARCHED (IPC)

C23C

The present search report has been drawn up for all claims

| Place of search | Date of completion of the search | Examiner |
|---|---|---|
| The Hague | 16 February 2024 | Castagné, Caroline |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
........................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 19 7691

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2024

| Patent document cited in search report | | Publication date | Patent family member(s) | | Publication date |
|---|---|---|---|---|---|
| EP 0436741 | B1 | 26-06-1996 | DE | 69027590 T2 | 05-12-1996 |
| | | | EP | 0436741 A1 | 17-07-1991 |
| | | | WO | 9102102 A1 | 21-02-1991 |
| US 6838181 | B1 | 04-01-2005 | AT | E403545 T1 | 15-08-2008 |
| | | | AU | 7279100 A | 19-03-2001 |
| | | | BR | 0013831 A | 23-04-2002 |
| | | | EP | 1216147 A1 | 26-06-2002 |
| | | | JP | 2003507305 A | 25-02-2003 |
| | | | US | 6838181 B1 | 04-01-2005 |
| | | | WO | 0114136 A1 | 01-03-2001 |
| US 2003132101 | A1 | 17-07-2003 | CN | 1464917 A | 31-12-2003 |
| | | | JP | 2002363733 A | 18-12-2002 |
| | | | KR | 20030024824 A | 26-03-2003 |
| | | | TW | 583325 B | 11-04-2004 |
| | | | US | 2003132101 A1 | 17-07-2003 |
| | | | WO | 02099159 A1 | 12-12-2002 |
| CN 103726019 | A | 16-04-2014 | NONE | | |

EPO FORM P0459

For more details about this annex : see Official Journal of the European Patent Office, No. 12/82

**EP 4 350 025 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 44791823
- US 63408404